(19) Europäisches Patentamt
European Patent Office
Office européen des brevets

(11) **EP 3 828 311 A1**

(12) **EUROPEAN PATENT APPLICATION**

(43) Date of publication:
**02.06.2021 Bulletin 2021/22**

(21) Application number: **19212307.3**

(22) Date of filing: **28.11.2019**

(51) Int Cl.:
*C23C 28/04* (2006.01)  *C23C 14/06* (2006.01)
*C23C 14/58* (2006.01)  *C23C 16/02* (2006.01)
*C23C 16/32* (2006.01)  *C23C 16/38* (2006.01)
*C23C 16/56* (2006.01)  *C23C 28/00* (2006.01)
*B26B 21/60* (2006.01)  *C23C 14/02* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **BIC-Violex S.A.**
**145 69 Anixi, Attiki (GR)**

(72) Inventors:
• **SIOZIOS, Anastasios**
**145 69 Anixi, Attiki (GR)**
• **Mavroeidis, Konstantinos**
**145 69 Anixi, Attiki (GR)**

(74) Representative: **Peterreins Schley**
**Patent- und Rechtsanwälte PartG mbB**
**Hermann-Sack-Strasse 3**
**80331 München (DE)**

(54) **RAZOR BLADE COATING**

(57)     Razor blade for a hand-held razor, the razor blade comprising a stainless steel razor blade substrate terminating in substrate edge portion, wherein the substrate edge portion has a continuously tapering geometry with two substrate sides converging towards a substrate edge; and wherein at least the substrate edge is provided with a hard coating comprising the elements titanium, boron, and carbon.

Fig. 1

**EP 3 828 311 A1**

**Description**

BACKGROUND OF THE DISCLOSURE

1. Field of the Present Disclosure

The present concept relates to razor blades and more particularly to razor blade edges and razor blade coatings.

2. Description of the Related Art

From the prior art, razor blades have been provided. Suitably placed in a razor cartridge, they offer the ultimate function of cutting hair or shaving. A shape of the razor blade and a coating of the razor blade play an important role in the quality of the shaving.

Razor blades are typically described by describing aspects of the cutting edge of the blade. The blade's cutting edge is often described as terminating in an edge portion which, in turn, terminates in the blade's ultimate edge (or simply blade edge). The blade's edge portion typically has a continuously tapering geometry with two sides converging towards and forming the blade edge. Considering the cross-section of the blade's edge portion, the blade edge is also called the blade tip. If the edge portion and blade edge are shaped robust, the razor blade will be subject to less wear and show a longer service life. However, such a blade profile will also result in larger cutting forces which adversely affect the shaving comfort. A thinner profile will lead to less cutting forces but will also increase the risk of breakage or damage and, thus, result in a shorter service life. Therefore, the profile of the razor blade's edge and edge portion is based on a trade-off between the cutting forces, the shaving comfort, and the service life that is desired.

The blade's edge and edge portion may be a multilayered structure in that the corresponding parts of the blade's substrate, typically a stainless steel substrate that has undergone grinding to form a continuously tapering geometry with two substrate sides converging towards a substrate edge, may be coated with various coatings to improve the cutting performance and shaving experience. In particular, the blade's edge may be coated to provide enhanced hardness which, in turn, enhances the blade's life expectancy.

However, providing a coating on a razor blade edge is a challenge for a number of reasons. First, because the substrate edge has a very peculiar geometry, depositing a coating on it which would operate as a suitable coating by enhancing the cutting properties and durability of the razor blade edge is very difficult. Second, razor blades are a mass consumption good, so the coatings must be consistently applied from product to product, and at a high throughput, which requires a coating compatible with a very reliable process. Third, and perhaps most importantly, razor blade edges have to be very thin and are often only a few micrometers in thickness at the blade edge. This lack in material thickness has a number of consequences when designing blade coatings: First of all, experiences of conventional tooling coatings cannot be readily transferred to razor blades. Conventional industrial tooling coatings are typically several micrometers (often up to 15 $\mu$m) in thickness and such bulky coatings cannot be readily applied to filigree razor blade edges. However, the bulkiness of industrial tooling coatings provides resistance against compressive stress and, thus, avoids fracture initiation and propagation in the coating. The bulkiness also intrinsically provides a certain degree of inherent fracture toughness since more bulk also means more sites in the coating material which can act as points of absorption of energy which would otherwise result in lattice dislocation movements and crack propagation. Finally, in comparison to conventional industrial tooling coatings, razor blades edges are so thin that distortions of the razor blade edge during the blade's cutting action are not negligible and induce stresses in the hard coating which exceed comparable stresses in conventional industrial tooling coatings. To summarize, the design of razor blade coatings is subject to a unique set of design considerations not shared with other coating applications. Therefore, it is unfortunately not a straight-forward exercise to apply conventional industrial tooling coatings to razor blades. Rather, it is necessary to thoroughly investigate potential coating candidates for their suitability as razor blade coatings.

There have been attempts to coat razor blades or to improve such coatings in the prior art. For example, WO 2006/027016 A1 discloses a razor blade coating comprising chromium and carbon. More recently, WO 2016/015771 A1 discloses a razor blade comprising a strengthening coating comprising titanium and boron. This application reports that razor blades with a TiB$_x$-containing coating preserve their cutting ability, shape and integrity in a more effective manner during cutting action than comparable blades coated with chromium and carbon.

However, despite the progress made in improving the hard coating of razor blades, there remains a need for further improvement of blade durability, in particular for blade designs which have particularly thin blade edges and low cutting forces.

SUMMARY OF THE DISCLOSURE

The present inventors have conducted diligent investigations to identify a coating which is suitable for application in razor blades and which is endowed with sufficient hardness but also elasticity and fracture toughness to provide the razor blade with improved wear resistance and resistance against degradation during use.

In one aspect, the present disclosure is directed towards a razor blade for a hand-held razor comprising a stainless steel razor blade substrate terminating in a substrate edge portion. The substrate edge portion may have a continuously tapering geometry with two substrate sides converging towards a substrate edge. At least the substrate edge may be provided with a hard coating comprising the elements titanium, boron, and carbon.

In some embodiments, the hard coating is directly provided on the substrate edge. Alternatively, the substrate edge may be indirectly provided with the hard coating comprising the elements titanium, boron, and carbon. In particular, in some embodiments, an adhesion-promoting coating is deposited at least onto the substrate edge to provide a first coated substrate edge and the hard coating comprising the elements titanium, boron, and carbon is deposited at least onto the first coated substrate edge.

In some embodiments, the hard coating may comprise titanium carbides and titanium borides. In some embodiments, the hard coating may further comprise boron carbides.

In some embodiments, the hard coating may comprise at least about 70 at %, more specifically at least about 80 at %, and in particular at least about 90 at %, of the elements titanium, boron, and carbon.

In some embodiments, the atomic ratio between boron and titanium may be between about 2.3:1 and about 1.2:1, more specifically between about 2.1:1 and about 1.4:1, and in particular between about 2.0 and about 1.5:1.

In some embodiments, the hard coating may comprise between about 2 and about 25 at % carbon, more specifically between about 4 and about 18 at % carbon, and in particular between about 5 and about 9 at % carbon.

In some embodiments, the hard coating may be composed of a single layer comprising titanium, boron and carbon.

In some embodiments, the hard coating may be composed of a plurality of sublayers, wherein a first set of sublayers comprises titanium and boron and a second set of sublayers comprises titanium and carbon. In some embodiments, the plurality of sublayers may form an alternating arrangement of layers comprising titanium carbide and layers comprising titanium boride. In some embodiments, the plurality of sublayers may comprise between about 3 and about 20 sublayers, more specifically between about 4 and about 15 sublayers, and in particular between about 6 and about 12 sublayers.

In some embodiments, the thickness of the hard coating may be between about 10 and about 500 nm, more specifically between about 50 and about 300 nm, and in particular between about 80 and about 250 nm. The thickness of the coating may be determined by measuring the thickness of the hard coating on the coated substrate edge.

In some embodiments, the adhesion-promoting first coating may comprise at least about 70 at %, more specifically at least about 80 at %, and in particular at least about 90 at %, of Ti, Cr, or TiC.

In some embodiments, the thickness of the adhesion-promoting coating may be between about 10 and about 100 nm, more specifically between about 10 and about 50 nm, and in particular between about 10 and about 35 nm. The thickness of the adhesion-promoting coating may be determined by measuring the thickness of the adhesion-promoting coating on first coated substrate edge.

In some embodiments, the ratio of thickness between the hard coating and the adhesion-promoting coating may be between about 20:1 to about 5:1, more specifically between about 14:1 to about 6:1, and in particular between about 12:1 to about 8:1. The thickness of the coating may be determined by measuring the thickness of the hard coating on the coated substrate edge. The thickness of the adhesion-promoting coating may be determined by measuring the thickness of the adhesion-promoting coating on first coated substrate edge.

In some embodiments, the cross-section of a blade's edge portion may have a substantially symmetrical tapering geometry terminating in a blade tip and the cross-section may have a central longitudinal axis originating from the blade tip. The blade's edge portion may have a thickness of between about 1.5 $\mu$m and about 2.4 $\mu$m measured at a distance of about 5 $\mu$m along the central longitudinal axis from the blade tip.

In a further aspect, the present disclosure is directed towards a razor cartridge comprising one or more razor blades as described in the above aspect.

BRIEF DESCRIPTION OF DRAWINGS

Fig. 1 is a schematic drawing of a razor blade's edge portion in cross-sectional view.
Figs 2a, 2b, and 2c show representative XPS measurements of a hard coating containing titanium, boron and carbon.
Fig. 3 is a schematic drawing of a razor blade's edge portion in cross-sectional view which comprises an adhesion-promoting coating.

DESCRIPTION OF SPECIFIC EMBODIMENTS

Hereinafter, a detailed description will be given of the present disclosure. The terms or words used in the description and the claims of the present disclosure are not to be construed limitedly as only having common-language or dictionary meanings and should, unless specifically defined otherwise in the following description, be interpreted as having their ordinary technical meaning as established in the relevant technical field. The detailed description will refer to specific embodiments and figures to better illustrate the present disclosure, however, it should be understood that the presented disclosure is not limited to these specific embodiments and the figures. The characteristics and advantages of the disclosure will readily appear from the following description of some of its embodiments, provided as non-limitative examples, and of the accompanying drawings.

In one aspect, the present disclosure is directed towards a razor blade for a hand-held razor. A razor blade is primarily composed of a stainless steel substrate which has undergone grinding to form an edge in the substrate. More specifically, the substrate is shaped such that it terminates in a substrate edge portion having substrate sides which converge towards a substrate edge.

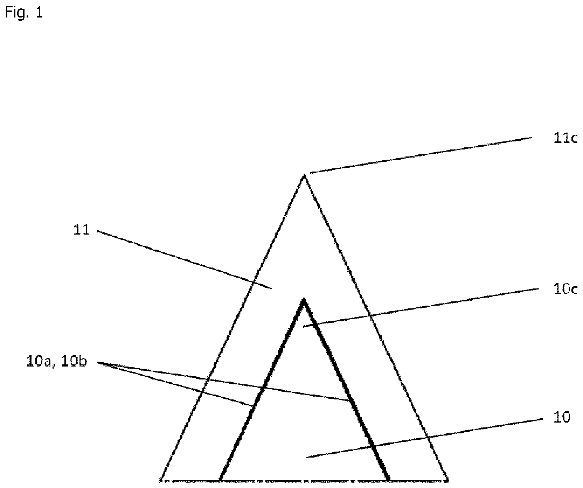

Fig. 1 shows an exemplary representation of a substrate edge portion 10. The substrate edge portion 10 has a continuously tapering geometry with two substrate sides 10a, 10b converging towards a substrate edge 10c. The continuously tapering geometry of the cross-sectional shape of the substrate edge portion 10 can be straight, angular, arched or any combination thereof. Moreover, the cross-sectional shape may be symmetrical or asymmetrical with respect a central longitudinal axis. Fig. 1 shows an exemplary cross-sectional shape of the substrate edge portion 10 which is symmetrical to the central longitudinal axis (not shown) and continuously tapering towards substrate edge 10c in a linear manner.

According to the present disclosure, at least the substrate edge 10c is provided with a hard coating 11 comprising the elements titanium, boron, and carbon. When referring to a substrate edge 10c which is provided with a hard coating 11, it should be understood that such reference does not merely refer to the strict geometrical edge of the substrate body but rather to the edge in view of the cutting action it performs. Accordingly, the term substrate edge 10c is also meant to encompasses those parts of the substrate sides 10a, 10b which are immediately adjacent to the strict geometrical edge of the substrate edge portion 10. In exemplary embodiments, the region forming the substrate edge 10c extends away from the strict geometric edge of the substrate edge portion along a central longitudinal axis of the substrate edge portion 10 for a distance of: about 5 $\mu$m or less, about 10 $\mu$m or less, about 15 $\mu$m or less, about 25 $\mu$m or less, about 50 $\mu$m or less, about 75 $\mu$m or less, about 100 $\mu$m or less, about 125 $\mu$m or less, about 150 $\mu$m or less, about 175 $\mu$m or less, or about 200 $\mu$m or less.

As schematically shown in Fig. 1, the hard coating 11 may not only be provided on the substrate edge 10c but additionally also be provided on the substrate sides 10a, 10b of the substrate edge portion 10. Extending the hard coating 11 to substrate sides 10a, 10b (or beyond) can be done on purpose to improve performance of the razor blade or it can be a by-product of the employed coating technology. The hard coating 11 may generally follow the surface and contour of the underlying substrate edge portion 10. Accordingly, the hard coating 11 may form the blades edge 11c, as shown in Fig. 1. However, it is not required that the hard coating 11 is in itself homogeneous, e.g. of homogeneous thickness and/or composition.

The hard coating 11 comprises the elements titanium, boron, and carbon. When referring to the elements titanium, boron, and carbon, it should be understood that these elements can be present in any form, for instance in their elemental form or chemically bound in intermetallic phases, in particular in borides or carbides. When referring to hard coating, it should be understood that the coating as such may be harder than the coated substrate portion and/or that the coated substrate portion may be hardened in its entirety in comparison to an uncoated substrate portion. For the purposes of the present disclosure, any coating comprising the elements titanium, boron, and carbon may be considered as a hard coating 11. However, it is also possible to determine the hardness of the hard coating 11 or hard coated substrate by using a nanoindenter as described in more detail in the Examples.

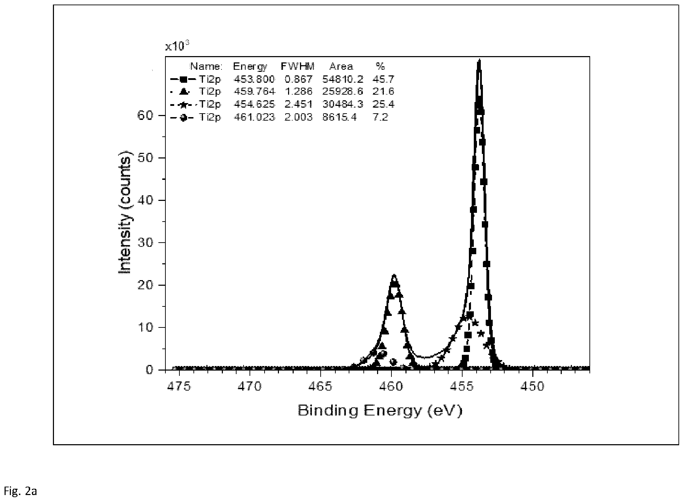

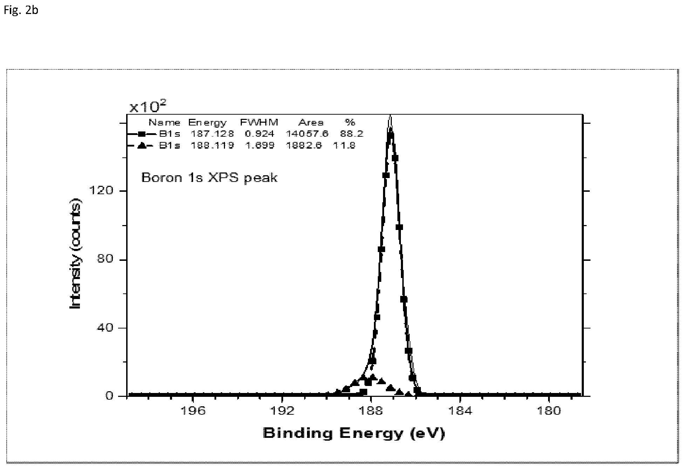

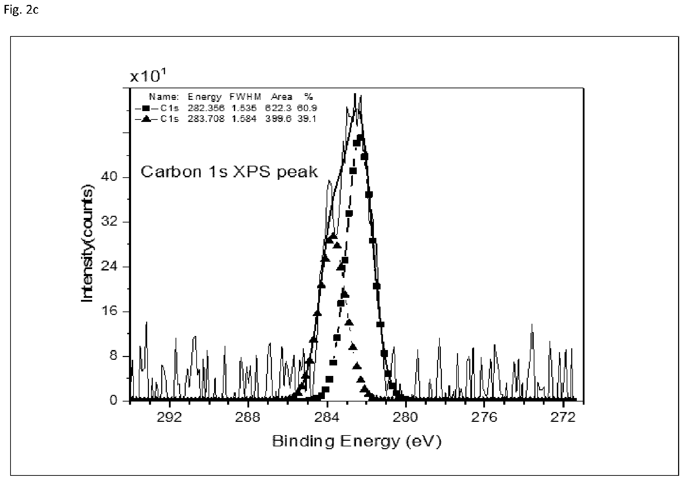

The method of determining the presence of the elements titanium, boron, and carbon in the hard coating 11 is not particularly limited. For instance, it is possible to detect these elements by chemical analysis of the blade edge using various common surface analysis methods such X-ray photoelectron spectroscopy (XPS), Auger Electron Spectroscopy (AES) which can provide quantitative and qualitative information on these elements, respectively. Figs 2a to 2c show exemplary results of an XPS measurement of a hard coating 11 containing titanium, boron, and carbon. As shown in Fig. 2a, the presence of titanium may be determined by measuring for the presence of a titanium 2p XPS peak at about 454 eV. As shown in Fig. 2b, the presence of boron may be determined by measuring for the presence of a boron Is XPS peak at about 188 eV. As shown in Fig. 2c, the presence of carbon may be determined by measuring for the presence of a carbon Is XPS peak at about 283 eV. Of course, other characteristic XPS peaks may be used as well.

The substrate of the razor blade may comprise a stainless steel. The choice of stainless steel is not particularly limited. A particularly suitable stainless steel may comprise iron as main alloying element, and, in weight, about 0.3 to about 0.9 % carbon, in particular about 0.49 to about 0.75 % of carbon, about 10 to about 18 % of chromium, in particular about 12.7 to about 14.5 % of chromium, about 0.3 to about 1.4 % of manganese, in particular about 0.45 to about 1.05% of manganese, about 0.1 to about 0.8 % of silicon, in particular about 0.20 to about 0.65% of silicon, and about 0.6% to about 2.0 % molybdenum, in particular about 0.85% to about 1.50% molybdenum. In some embodiments, the stainless steel may substantially consist of the above-cited elements and, in particular, may not contain more than about 3% by weight, in particular about 2 % by weight, other elements.

In some embodiments, for instance as shown in Fig. 1, the hard coating 11 may be provided directly on the substrate edge portion 10. In some embodiments, the hard coating 11 may be deposited onto the substrate edge portion 10.

In some embodiments, it may be advantageous that the razor blade further comprises an adhesion-promoting coating to facilitate secure attachment of hard coating 11 to the substrate edge portion. In particular, in some embodiments, an adhesion-promoting coating is deposited at least onto the substrate edge 10c to provide a first coated substrate edge and the hard coating 11 comprising the elements titanium, boron, and carbon is deposited at least onto the first coated substrate edge.

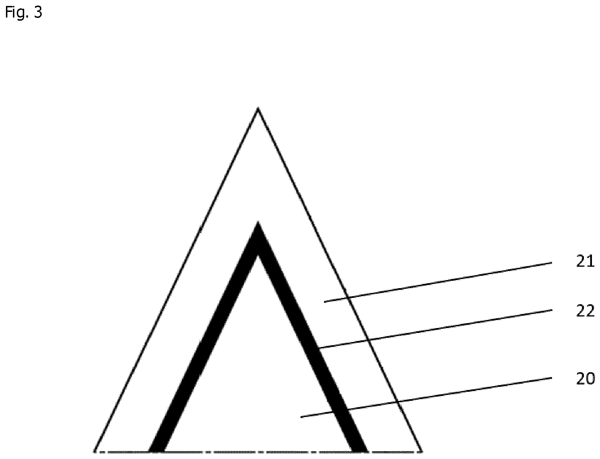

An exemplary embodiment comprising an adhesion-promoting coating is shown in Fig. 3. Fig. 3 shows an exemplary representation of substrate edge portion 20. The substrate edge portion 20, including the substrate edge itself, is coated with an adhesion-promoting coating 22. The adhesion-promoting coating 22 is then coated with hard coating 21. The adhesion-promoting coating 22 may not only be provided on the substrate edge 10c but additionally also be provided on the substrate sides 10a, 10b of the substrate edge portion 10.

The type of adhesion-promoting coating 22 is not particularly limited. In some embodiments, the adhesion-promoting first coating 22 may comprise at least about 70 at %, more specifically at least about 80 at %, and in particular at least about 90 at %, of Ti, Cr, or TiC.

In some embodiments, the thickness of the adhesion-promoting coating 22 may be between about 10 and about 100 nm, more specifically between about 10 and about 50 nm, and in particular between about 10 and about 35 nm.

In some embodiments, the hard coating 11, 21 may comprise titanium carbides and titanium borides. In some embodiments, the hard coating 11, 21 may further comprise boron carbides. Such carbides and borides will typically form when depositing the elements titanium, boron, and carbon by thin-film deposition techniques such as Physical Vapor Deposition (PVD), Chemical Vapor Deposition (CVD), and related techniques. In some embodiments, hard coating 11, 21 may comprise a $TiB_2$-based matrix and carbon is dispersed within said matrix. In some embodiments, the dispersed carbon may form local bonds with titanium and boron, respectively. In some embodiments, the dispersed carbon may not form local bonds with titanium and boron, respectively.

While the hard coating 11, 21 may primarily comprise the elements titanium, boron, and carbide, it should be understood that the hard coating 11, 21 may contain other elements as well. Other elements may be present as impurities, may stem from ingress of elements from the blade substrate, or may be purposively added to fine-tune certain properties. In some embodiments, the hard coating 11, 21 may comprise at least about 70 at %, more specifically at least about 80 at %, and in particular at least about 90 at %, of the elements titanium, boron, and carbon.

In some embodiments, the hard coating 11, 21 may further comprise a lubricating phase, such as molybdenum disulfide ($MoS_2$). These coating additives may provide a lower friction coefficient and may be co-sputtered with the hard coating 11, 21. This way, the lubricating phase may be provided to the entire coating volume, reducing the friction coefficient and maintaining the hardness of the razor blade in high level even after initial surface abrasion. In addition, the cutting forces incurred by a razor blade bearing a multi-phase coating may be reduced during shaving, compared to the cutting forces incurred by a razor blade bearing the same coating but absent the lubricating phase.

While hard coatings 11, 21 comprising titanium, boron and carbon generally have improved wear resistance due to a very suitable combination of hardness, fracture toughness to inhibit fracture initiation and propagation and resistance against compressive stresses to inhibit fracture propagation, the present inventors have surprisingly also found that suitably adjusting the atomic ratio of titanium, boron and carbon further improves the wear resistance of the razor blade.

Accordingly, in some embodiments, the atomic ratio between boron and titanium may be between about 2.3:1 and about 1.2:1. The method of determining said atomic ratio is not particularly limited and can, for instance, be done by Energy Dispersive X-rays (EDX), X-ray Photoelectron Spectroscopy (XPS), Auger Electron Spectroscopy (AES), X-ray Fluorescence (XRF), and Secondary-ion mass spectrometry (SIMS). In some embodiments, it may be advantageous that the atomic ratio between boron and titanium is between about 2.3 and about 1.2:1, more specifically between about 2.1 and about 1.4:1, and in particular between about 2.0 and about 1.5:1.

In some embodiments, the hard coating 11, 21 may comprise between about 2 and about 25 at % carbon. The method of determining the amount of carbon in the coating is not particularly limited and can be done by the same methods as outlined above for the atomic ratio between boron and titanium. In some embodiments, it may be advantageous that the hard coating 11, 21 comprises between about 4 and about 18 at % carbon, more specifically between about 4.5 and about 14 at % carbon, and in particular between about 5 and about 9 at % carbon.

In some embodiments, it may be advantageous that the atomic ratio between boron and titanium in the hard coating 11, 21 is between about 2.1 and about 1.4:1 and that hard coating 11, 21 comprises between about 4 and about 18 at % carbon.

In some embodiments, it may be advantageous that the atomic ratio between boron and titanium in the hard coating 11, 21 is between about 2.1 and about 1.4:1 and that hard coating 11, 21 comprises about 4.5 and about 14 at % carbon, and in particular between about 5 and about 9 at % carbon.

In some embodiments, it may be advantageous that the atomic ratio between boron and titanium in the hard coating 11, 21 is between about 1.9 and about 1.4:1, and in particular between about 2.0 and about 1.5:1 and that hard coating 11, 21 comprises between about 4 and about 18 at % carbon.

In some embodiments, it may be advantageous that the atomic ratio between boron and titanium in the hard coating 11, 21 is between about 1.9 and about 1.4:1, and in particular between about 2.0 and about 1.5:1; that hard coating 11, 21 comprises about 4.5 and about 14 at % carbon, and in particular between about 5 and about 9 at % carbon; and that the hard coating 11, 21 comprises at least about 70 at %, more specifically at least about 80 at %, and in particular at least about 90 at %, of the elements titanium, boron, and carbon.

The deposition methods which are suitable for depositing hard coatings 11, 21 allow numerous designs of the hard coating 11, 21. Accordingly, in some embodiments, the hard coating 11, 21 may be composed of a single layer comprising titanium, boron and carbon. In some embodiments, the hard coating 11, 21 may be composed of a plurality of sublayers, wherein a first set of sublayers comprises titanium and boron and a second set of sublayers comprises titanium and carbon. In some embodiments, the plurality of sublayers may form an alternating arrangement of layers comprising titanium carbide and layers comprising titanium boride. In some embodiments, the plurality of sublayers may comprise between about 3 and about 20 sublayers, more specifically between about 4 and about 15 sublayers, and in particular between about 6 and about 12 sublayers. In some embodiments, sublayers comprising titanium carbide may have a thickness of about 1 to about 4 nm, in particular about 2 to about 3 nm, and sublayers comprising titanium boride may have a thickness of about 0.5 to about 2 nm, in particular about 0.8 to about 1.3 nm.

In some embodiments, the thickness of the hard coating 11, 21 may be between about 10 and about 500 nm, more specifically between about 50 and about 300 nm, and in particular between about 80 and about 250 nm.

In some embodiments, the ratio of thickness between the hard coating 11,21 and the adhesion-promoting coating 22 may be between about 20:1 to about 5:1, more specifically between about 14:1 to about 6:1, and in particular between about 12:1 to about 8:1.

The razor blade may further comprise additional coatings. In one embodiment, the razor blade further comprises an outer layer which is provided on the hard coating 11, 21. The outer layer may be a lubricating layer, which may comprise a fluoropolymer, in particular polytetrafluoro ethylene (PTFE). The lubricating layer serves to reduce friction during shaving. In other embodiments, other hydrophilic coatings such as silicon-based lubricants, e.g. polydimethyl siloxane (PDMS) or lubricating coatings comprising polyethylene glycol (PEG) may also be applied to provide a lubricating effect. In another embodiment, the razor blade further comprises a chromium-containing top coating that is provided on the hard coating 16. In case that both a chromium-containing top coating and a lubricating layer is used, the lubricating layer is provided over the chromium-containing top coating whereas the chromium-containing top coating is provided over the hard coating 11, 21.

As explained above, the improved wear resistance due to a very suitable combination of hardness, fracture toughness and resistance against compressive stresses makes hard coatings 11, 21 particularly suitable for relatively thin blade edge designs. Accordingly, in some embodiments, the cross-section of the razor blade's edge portion may have a substantially symmetrical tapering geometry terminating in a blade tip, wherein the cross-section has a central longitudinal axis originating from the blade tip, and wherein the blade's edge portion has a thickness of between about 1.5 $\mu$m and about 2.4 $\mu$m, in particular about 1.57 to about 2.35 $\mu$m, measured at a distance of about 5 $\mu$m along the central longitudinal axis from the blade tip. In some embodiments, the blade's edge portion has a thickness of between about 4.6 $\mu$m and about 6.8 $\mu$m, in particular about 4.62 to about 6.74 $\mu$m, measured at a distance of about 20 $\mu$m along the central longitudinal axis from the blade tip. In some embodiments, the blade's edge portion has a thickness of between about 10.3 $\mu$m and 14.4 $\mu$m, in particular about 10.32 to about 14.35 $\mu$m, measured at a distance of about 50 $\mu$m along the central longitudinal axis from the blade tip. In some embodiments, the blade's edge portion has a thickness of between about 19.8 $\mu$m and 27.6 $\mu$m, in particular about 19.82 to about 27.52 $\mu$m, measured at a distance of about 100 $\mu$m along the central longitudinal axis from the blade tip.

The above-described razor blades can be manufactured by any suitable means. More specifically, the preparation and grinding of the blade substrate can be performed by any suitable means, for instance as disclosed in US 2017/136641 A1 which is incorporated by reference in its entirety.

The coatings may also be applied by any suitable means. Both the hard coating 16 and the adhesion promoting coating 18 may be deposited by using thin film deposition technologies such as Physical Vapor Deposition (PVD) and Chemical Vapor Deposition (CVD), respectively. In particular, in the family of PVD technologies, DC Sputtering, RF Sputtering, Closed Field Unbalanced Magnetron Sputtering (CFUMS), Ion Beam Sputtering, Cathodic Arc Deposition, and High-Power Impulse Magnetron Sputtering (HiPIMS) may be utilized using sintered TiBC targets in an Ar atmosphere.

It is also possible to provide the hard coating 16 by co-sputtering of $TiB_2$ and TiC sintered targets in an Ar atmosphere or $TiB_2$ and C targets in an Ar atmosphere. Hard coatings 16 can also be deposited using a $TiB_2$ coating in Ar/$CH_4$ atmosphere. Examples of a CVD technology for producing hard coating 16 include Low Pressure CVD (LPCVD), Atmospheric Pressure CVD (APCVD), Atomic Layer Deposition (ALD), and Metalorganic CVD (MOCVD) using precursors. An exemplary deposition process is described in US 2018/215056 A1 and US 10,442,098 B2, both of which are incorporated by reference in their entirety. In some cases, it may be that the method selected for depositing the hard coating 11, 21 may introduce some statistical variability to the chemical composition of the hard coating 11, 21 in an industrial mass-production setting. Therefore, in some embodiments, it may be advantageous that the atomic percentages and ratios indicated elsewhere in this specification are referring to the average determined from multiple measurements, for instance the average of 5 measurements.

The outer coating such as a lubricating coating may also be applied by any suitable means. Manufacturing methods are well-known to the skilled person.

In a further aspect, the present disclosure is directed towards a razor cartridge comprising one or more razor blades as described in the above aspect.

In the following, an exemplary method of preparing a razor blade coating according to the first aspect of the disclosure will be described in more detail:

After loading the blade bayonets on the rotating fixture of a depositing chamber, the chamber is evacuated up to a base pressure of $10^{-5}$ Torr. Then Ar gas is inserted into the chamber up to a pressure of 8 mTorr (8 X $10^{-3}$ Torr). Rotation of the blade bayonets begins at a constant speed of 6 rpm and the targets are operated under DC current control at 0.2 Amps. A DC voltage of 200-600 V is applied on the stainless steel blades for 4 minutes in order to perform a sputter etching step. In another embodiment, a Pulsed DC voltage of 100-600 V may be applied on the stainless steel blades for 4 minutes to perform a sputter etching step.

Next, the deposition of an adhesion-promoting interlayer takes place after the end of sputter etching step, with the chamber pressure being adjusted to 3 mTorr. The interlayer target is operated under DC current control at 3-10 Amps while a DC voltage of 0-100 V is applied on the rotating blades. Adjusting the deposition time, an interlayer of 5-50 nm is deposited prior to depositing the hard coating layer. In another embodiment, a Pulsed DC voltage of 0-100V may be applied during the deposition of the interlayer.

After deposition of the interlayer, a TiBC compound film is deposited on top of it forming the hard coating. $TiB_2$ and C targets are operated simultaneously. The relative amount of deposited C can be controlled by varying the C target current from e.g. 1 Amp to 7 Amps while keeping the $TiB_2$ target(s) current constant. During the deposition a DC bias voltage of 0 to -600 V is applied on the rotating blades.

Finally, on top of the hard coating layer, a Cr top layer may be deposited with the current on the Cr target(s) at 3 Amps and a bias voltage of 0-450 V.

As explained above, in some embodiments any of the hard coating 11, 21 or the adhesion-promoting coating 22 may not only be provided on the substrate edge 10c but additionally also be provided on the substrate sides 10a, 10b of the substrate edge portion 10.

EXAMPLES

Following the above-outlined manufacturing procedure, TiBC hard coatings of varying compositions (Examples 1 to 5) were deposited on stainless steel blade substrates. The relative composition of the TiBC hard coating was changed by varying the C target current while the $TiB_2$ target(s) current was kept constant. All other parameters and conditions remained unchanged. During the deposition a DC bias voltage of 0 to -600 V is applied on the rotating blades. The obtained chemical compositions of the obtained hard coatings were analyzed by XPS. The results are shown in below table 1:

Table 1:

| Example | [Ti] in at % | [B] in at % | [B]/ [Ti] | [C] in at % |
|---|---|---|---|---|
| Comparative Example | not tested | not tested | - | not tested |
| Example 1 | 32.5 | 59.6 | 1.84 | 2.4 |
| Example 2 | 30.6 | 58.7 | 1.92 | 5.5 |
| Example 3 | 30.2 | 56.3 | 1.86 | 8.1 |
| Example 4 | 28.9 | 48.5 | 1.67 | 17.2 |
| Example 5 | 27.8 | 42.9 | 1.54 | 21.2 |

Thus, modulating the C target current yielded co-sputtered $TiB_2$/C-hard coatings comprising the concentrations of C:

Table 2:

| Example | Carbon target current (Amps) | C concentration (at %) |
|---|---|---|
| Comparative Example | 0 | 0 |
| Example 1 | 0.3 | 2.4 |
| Example 2 | 1 | 5.5 |
| Example 3 | 2 | 8.1 |
| Example 4 | 5 | 17.2 |
| Example 5 | 7 | 21.2 |

Nanoindentation tests were performed on representative samples of TiBC hard coatings which were obtained using the above-specified process parameters. Briefly summarized, the nanoindentation test was performed as follows: During the nanoindentation process, a hard tip whose properties (mechanical properties, geometry, tip radius etc.) are known, penetrates the hard coating sample to be analyzed. In the present case a Berkovich tip was used for the indentation tests. The load enforced on the indenter tip was increased as the tip penetrated further into the specimen until penetration depth of 50-100 nm was reached. At this point, the load was held constant for a period of time and then the indenter was removed. The area of the residual indentation in the sample was measured. The hardness **H** is defined as the maximum load **$P_{max}$** divided by the residual indentation area **A**:

$$H = \frac{Pmax}{A}$$

The following results were obtained:

Table 3:

| Example | C concentration (at %) | Hardness (GPa) |
|---|---|---|
| Comparative Example | 0 | 15.13 |
| Example 1 | 2.4 | 15.69 |
| Example 2 | 5.5 | 17.14 |
| Example 3 | 8.1 | 17.75 |
| Example 4 | 17.2 | 17.15 |
| Example 5 | 21.2 | 16.94 |

As can be seen from above table 3, a hard coating comprising Ti and B provides a hardness of 15.13 GPa (Comparative Example). If carbon is dispersed in the $TiB_2$ matrix, the hardness is improved in all cases (Comparative Example vs. Examples 1 to 5). Moreover, it was surprisingly found that the hardness does not vary linearly with the amount of carbon dispersed in the $TiB_2$ matrix but, rather, has an optimum at specific C concentrations (Examples 2, 3, and 4).

Furthermore, the blade edge degradation of razor blades coated with TiBC hard coatings was evaluated. In particular, razor blades prepared as described for the Comparative Example having a conventional $TiB_2$ hard coating where compared to razor blades prepared as described for the best-performing Example 3 and Example 4 having TiBC hard coatings. The evaluation was carried out as follows:

10 blades per sample lot were subjected to 20 consecutive cuts on a moving felt using a load cell for measuring the load on the blade in the cutting action. It was found that the load ranges for the last 20th cuts of the TiBC-coated blades were at least equal with the load of blades having the comparative $TiB_2$ hard coating. This indicated that the blades with the TiBC coating preserve their cutting ability (i.e. shape and integrity) during the cutting action. Additionally, the damage imposed on the blade edge after 20 cuts during the above-described test was evaluated with the aid of an optical microscope. The damage on the blade edge was quantified in terms of area of missing material, i.e. material that has been broken and removed from the edge. The results are reported in the below table 4.

Table 4:

| Example | Force at 20th cut (Kg) | Missing Area ($\mu m^2$) | Missing Length ($\mu m$) |
|---|---|---|---|
| Comparative Example | 2.65 | 3265 | 1333 |
| Example 3 | 2.67 | 2826 | 1202 |
| Example 4 | 2.59 | 1700 | 745 |

The TiBC coated blades of Examples 3 and 4 demonstrated an up to about 50% decrease of the missing material area as compared to blades with the $TiB_2$ coating of the Comparative Example. Likewise, the missing lengths of the blade edge was substantially improved. The above shows that coating razor edges with TiBC coatings improves the wear resistance and resistance against degradation during use.

Although the embodiments of the present disclosure have been disclosed for illustrative purposes, those skilled in the art will appreciate that various modifications and alterations are possible, without departing from the spirit of the present disclosure. It is also to be understood that such modifications and alterations are incorporated in the scope of the present disclosure and the accompanying claims.

**Claims**

1. Razor blade for a hand-held razor, the razor blade comprising a stainless steel razor blade substrate terminating in substrate edge portion, wherein the substrate edge portion has a continuously tapering geometry with two substrate sides converging towards a substrate edge; and
wherein at least the substrate edge is provided with a hard coating comprising the elements titanium, boron, and carbon.

2. The razor blade according to claim 1, wherein an adhesion-promoting coating is deposited at least onto the substrate edge to provide a first coated substrate edge and the hard coating is deposited at least onto the first coated substrate edge.

3. The razor blade according to claim 1 or claim 2, wherein the hard coating comprises titanium carbides and titanium borides.

4. The razor blade according to any one of claims 1 to 3, wherein the hard coating comprises at least about 70 at %, more specifically at least about 80 at %, and in particular at least about 90 at %, of the elements titanium, boron, and carbon.

5. The razor blade according to any one of claims 1 to 4, wherein an atomic ratio between boron and titanium in the hard coating is between about 2.3:1 and about 1.2:1, more specifically between about 2.1:1 and about 1.4:1, and in particular between about 2.0 and about 1.5:1.

6. The razor blade according to any one of claims 1 to 5, wherein the hard coating comprises between about 2 and about 25 at % carbon, more specifically between about 4 and about 18 at % carbon, and in particular between about 5 and about 9 at % carbon.

7. The razor blade according to any one of claims 1 to 6, wherein the hard coating is composed of a single layer comprising titanium, boron and carbon; or wherein the hard coating is composed of a plurality of sublayers, wherein a first set of sublayers comprises titanium and boron and a second set of sublayers comprises titanium and carbon.

8. The razor blade according to claim 7, wherein the plurality of sublayers forms an alternating arrangement of layers comprising titanium carbide and layers comprising titanium boride.

9. The razor blade according to claim 7 or claim 8, wherein the plurality of sublayers comprises between about 3 and about 20 sublayers, more specifically between about 4 and about 15 sublayers, and in particular between about 6 and about 12 sublayers.

10. The razor blade according to any one of claims 1 to 9, wherein a thickness of the hard coating is between about 10 and about 500 nm, more specifically between about 50 and about 300 nm, and in particular between about 80 and about 250 nm.

11. The razor blade according to any one of claims 2 to 10, wherein the adhesion-promoting coating comprises at least about 70 at %, more specifically at least about 80 at %, and in particular at least about 90 at %, Ti, Cr, or TiC.

12. The razor blade according to any one of claims 2 to 11, wherein a thickness of the adhesion-promoting coating is between about 10 and about 100 nm, more specifically between about 10 and about 50 nm, and in particular between about 10 and about 35 nm.

13. The razor blade according to any one of claims 2 to 12, wherein a ratio of thickness between the hard coating and the adhesion-promoting coating is between about 20:1 and about 5:1, more specifically between about 14:1 and about 6:1, and in particular between about 12:1 and about 8:1.

14. The razor blade according to any one of claims 1 to 13, wherein the cross-section of a blade edge portion has a substantially symmetrical tapering geometry terminating in a blade tip, wherein the cross-section has a central longitudinal axis originating from the blade tip, and wherein the blade's edge portion has a thickness of between about 1.5 $\mu$m and about 2.4 $\mu$m measured at a distance of about 5 $\mu$m along the central longitudinal axis from the blade tip.

15. A razor cartridge comprising one or more razor blades according to any of claims 1-14.

Fig. 1

11c

11

10c

10a, 10b

10

Fig. 2a

Fig. 2b

Fig. 2c

Fig. 3

21

22

20

Europäisches
Patentamt

European
Patent Office

Office européen
des brevets

## EUROPEAN SEARCH REPORT

Application Number

EP 19 21 2307

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/184723 A1 (BIC VIOLEX SA [GR]) 11 October 2018 (2018-10-11) * paragraphs [0014], [0027], [0028], [0031], [0033], [0034]; figures 1-5 * | 1-15 | INV. C23C28/04 C23C14/06 C23C14/58 C23C16/02 |
| X,D | US 2017/136641 A1 (SIOZIOS ANASTASIOS [GR] ET AL) 18 May 2017 (2017-05-18) * paragraphs [0050], [0085], [0102]; claims 1, 13; figures 2, 16 * | 1,3-5,7, 10,15 | C23C16/32 C23C16/38 C23C16/56 C23C28/00 B26B21/60 |
| X | WO 92/17323 A1 (WARNER LAMBERT CO [US]) 15 October 1992 (1992-10-15) * claims 1, 10, 16; figure 1 * | 1,3,7, 10,15 | C23C14/02 |
| X | EP 0 850 126 A2 (WARNER LAMBERT CO [US]) 1 July 1998 (1998-07-01) * paragraphs [0028], [0032]; claims 1-9; figures 1-3 * | 1-3,7, 11,12,15 | |

TECHNICAL FIELDS
SEARCHED      (IPC)

C23C
B26B

The present search report has been drawn up for all claims

| Place of search | Date of completion of the search | Examiner |
|---|---|---|
| The Hague | 14 April 2020 | Chalaftris, Georgios |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 19 21 2307

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2020

| Patent document cited in search report | | Publication date | Patent family member(s) | | Publication date |
|---|---|---|---|---|---|
| WO 2018184723 | A1 | 11-10-2018 | CN | 110366605 A | 22-10-2019 |
| | | | EP | 3607106 A1 | 12-02-2020 |
| | | | KR | 20190133669 A | 03-12-2019 |
| | | | WO | 2018184723 A1 | 11-10-2018 |
| US 2017136641 | A1 | 18-05-2017 | NONE | | |
| WO 9217323 | A1 | 15-10-1992 | AU | 1772292 A | 02-11-1992 |
| | | | DE | 69226266 D1 | 20-08-1998 |
| | | | DE | 69226266 T2 | 17-12-1998 |
| | | | EP | 0579756 A1 | 26-01-1994 |
| | | | JP | H06508533 A | 29-09-1994 |
| | | | WO | 9217323 A1 | 15-10-1992 |
| EP 0850126 | A2 | 01-07-1998 | AU | 703731 B2 | 01-04-1999 |
| | | | CA | 2228215 A1 | 20-03-1997 |
| | | | DE | 69611682 D1 | 01-03-2001 |
| | | | DE | 69611682 T2 | 31-05-2001 |
| | | | EP | 0850126 A2 | 01-07-1998 |
| | | | JP | H11512317 A | 26-10-1999 |
| | | | US | 5630275 A | 20-05-1997 |
| | | | WO | 9710083 A2 | 20-03-1997 |
| | | | ZA | 9607334 B | 04-03-1997 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006027016 A1
- WO 2016015771 A1
- US 2017136641 A1
- US 2018215056 A1
- US 10442098 B2